# EUROPEAN PATENT APPLICATION

(11) **EP 1 492 167 A2**
(43) Date of publication of application: **29.12.2004**
(21) Application number: 04076759.2
(22) Date of filing: 14.06.2004
(51) Int. Cl.: H01L 27/00, H01L 51/30, C09K 11/06

(54) **White light-emitting oled device having a blue light-emitting layer doped with an electron-transporting or a hole-transporting material or both**

(30) Priority: 26.06.2003 US 606446
(71) Applicant: EASTMAN KODAK COMPANY, Rochester, New York 14650 (US)
(72) Inventor: Hatwar, Tukaram K. c/o Eastman Kodak Company, Rochester New York 14650-2201 (US); Ricks, Michele L. c/o Eastman Kodak Company, Rochester New York 14650-2201 (US); Winters, Dustin L. c/o Eastman Kodak Company, Rochester New York 14650-2201 (US); Spindler, Jeffrey P. c/o Eastman Kodak Company, Rochester New York 14650-2201 (US)
(74) Representative: Weber, Etienne Nicolas

(57) **Abstract**

An organic light-emitting diode (OLED) device which produces substantially white light includes an anode; a hole-transporting layer disposed over the anode; and a blue light-emitting layer having a host doped with a blue light-emitting compound disposed directly on the hole-transporting layer and the blue light-emitting layer being doped with an electron-transporting or a hole-transporting material or both selected to improve efficiency and operational stability. The device also includes an electron-transporting layer disposed over the blue light-emitting layer; a cathode disposed over the electron-transporting layer; and the hole-transporting layer or electron-transporting layer, or both the hole-transporting layer and electron-transporting layer, being selectively doped with a compound which emits light in the yellow region of the spectrum which corresponds to an entire layer or a partial portion of a layer in contact with the blue light-emitting layer.

## Description

The present invention relates to organic light-emitting OLED devices, which produce white light with an enhanced blue light component.

An OLED device includes a substrate, an anode, a hole-transporting layer made of an organic compound, an organic luminescent layer with suitable dopants, an organic electron-transporting layer, and a cathode. OLED devices are attractive because of their low driving voltage, high luminance, wide-angle viewing and capability for full-color flat emission displays. Tang and others described this multilayer OLED device in US-A-4,769,292 and US-A-4,885,211.

Efficient white light producing OLED devices are considered a low cost alternative for several applications such as paper-thin light sources, backlights in LCD displays, automotive dome lights, and office lighting. White light producing OLED devices should be bright, efficient, and generally have Commission International d'Eclairage (CIE) chromaticity coordinates of about (0.33, 0.33). In any event, in accordance with this disclosure, white light is that light which is perceived by a user as having a white color.

The following patents and publications disclose the preparation of organic OLED devices capable of emitting white light, comprising a hole-transporting layer and an organic luminescent layer, and interposed between a pair of electrodes.

White light producing OLED devices have been reported by J. Shi (US-A-5,683,823) wherein the luminescent layer includes red and blue light-emitting materials uniformly dispersed in a host emitting material. This device has good electroluminescent characteristics, but the concentration of the red and blue dopants are very small, such as 0.12% and 0.25% of the host material. These concentrations are difficult to control during large-scale manufacturing. Sato and others in JP 7,142,169 disclose an OLED device, capable of emitting white light, made by placing a blue light-emitting layer next to the hole-transporting layer and followed by a green light-emitting layer having a region containing a red fluorescent layer. Kido and others, in Science, Vol. 267, p. 1332 (1995) and in APL Vol. 64, p. 815 (1994), report a white light producing OLED device. In this device three emitter layers with different carrier transport properties, each emitting blue, green or red light, are used to generate white light. Littman and otehrs in US-A-5,405,709 disclose another white emitting device, which is capable of emitting white light in response to hole-electron recombination, and comprises a fluorescent in a visible light range from bluish green to red. Recently, Deshpande and others, in Applied Physics Letters, Vol. 75, p. 888 (1999), published a white OLED device using red, blue, and green luminescent layers separated by a hole blocking layer.

However, these OLED devices require very small amounts of dopant concentrations, making the process difficult to control for large-scale manufacturing. Also, emission color varies due to small changes in the dopant concentration. Full-color devices are made by combining white OLEDs with color filters. However, the color filter transmits only about 30% of the original light. Thus, when the white light is passed through the blue color filter, the blue component is very low in luminance intensity. Due to its low intensity, the blue channel of the R, G, B full-color display is required to operate at much higher current density. This reduces the lifetime of the blue color.

It is therefore an object of the present invention to produce an effective white light-emitting organic device with improved efficiency and operational stability of blue light emission.

This object is achieved by an organic light-emitting diode (OLED) device which produces substantially white light, comprising:
a) an anode;
b) a hole-transporting layer disposed over the anode;
c) a blue light-emitting layer having a host doped with a blue light-emitting compound disposed directly on the hole-transporting layer and the blue light-emitting layer being doped with an electron-transporting or a hole-transporting material or both selected to improve efficiency and operational stability;
d) an electron-transporting layer disposed over the blue light-emitting layer;
e) a cathode disposed over the electron-transporting layer; and
f) the hole-transporting layer or electron-transporting layer, or both the hole-transporting layer and electron-transporting layer, being selectively doped with a compound which emits light in the yellow region of the spectrum which corresponds to an entire layer or a partial portion of a layer in contact with the blue light-emitting layer.

The following are features and advantages of the present invention.

White light OLED devices, in accordance with the present invention, have significantly improved device efficiency and operational stability. More particularly, by adding a hole-transporting or electron-transporting material as co-dopants in a small amount along with the blue emitting dopant to the blue light-emitting layer, significant improvements can be achieved.

High efficiency white OLEDs can be used to fabricate full-color devices using the substrate with the on chip color filters (OCCF) and integrated thin film transistors.

OLED devices made in accordance with the present invention eliminate the need for using a shadow mask for making light-emitting layers in full-color OLED devices.

OLED devices made in accordance with the present invention can be produced with high reproducibility and consistency to provide high light efficiency.

These devices have high operational stability and also require low drive voltage.
FIG. 1 depicts a prior art organic light-emitting device;
FIG. 2 depicts another prior art organic light-emitting device;
FIG. 3 depicts a white light producing OLED device wherein the hole-transporting layer is doped with the super rubrene yellow dopant;
FIG. 4 depicts another structure of white light producing OLED device wherein hole-transporting layer is doped with super rubrene yellow dopant and has two sublayers;
FIG. 5 depicts a white light producing OLED device wherein the electron-transporting layer is doped with yellow dopant;
FIG. 6 depicts another structure of white light producing OLED device wherein both the hole-transporting layer and the electron-transporting layer are doped with yellow dopant;
FIG. 7 depicts another structure of white light producing OLED device wherein both the hole-transporting layer and the electron-transporting layer are doped with yellow dopant and has two sublayers;
FIG. 8 depicts a white light producing OLED device wherein the hole-transporting layer is doped with the yellow dopant and has an additional green-emitting layer;
FIG. 9 depicts another structure of white light producing OLED device wherein the hole-transporting layer is doped with yellow dopant and has two sublayers and has an additional green-emitting layer;
FIG. 10 depicts a white light producing OLED device wherein the electron-transporting layer is doped with yellow dopant and has an additional green-emitting layer;
FIG. 11 depicts another structure of white light producing OLED device wherein both the hole-transporting layer and the electron-transporting layer are doped with yellow dopant and has an additional green-emitting layer; and
FIG. 12 depicts another structure of white light producing OLED device wherein both the hole-transporting layer and the electron-transporting layer are doped with yellow dopant and has two sublayers, and has an additional green-emitting layer.

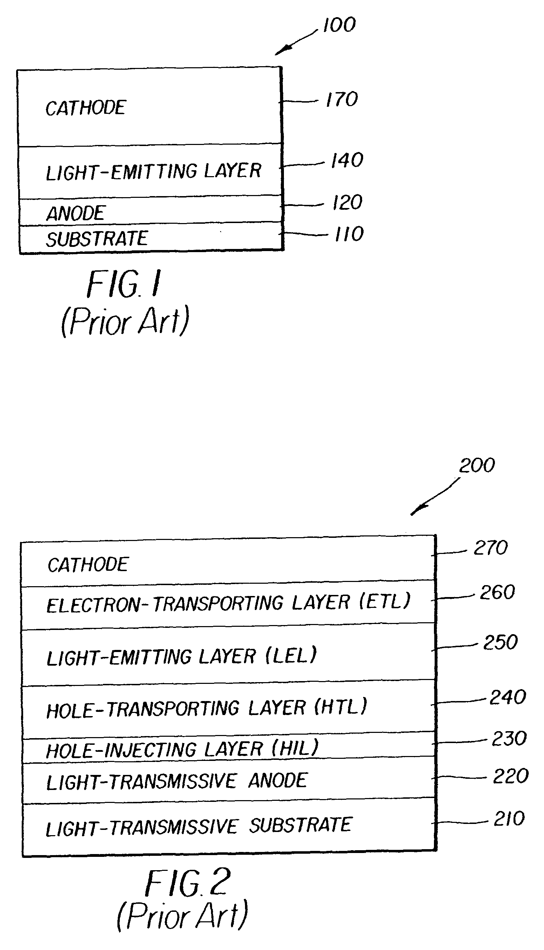

A conventional light-emitting layer of the organic OLED device comprises a luminescent or fluorescent material where electroluminescence is produced as a result of electron-hole pair recombination in this region. In the simplest construction, the device 100 as shown in FIG. 1 has a substrate 110 and a light-emitting layer 140 sandwiched between anode 120 and cathode 170. The light-emitting layer 140 is a pure material with a high luminescent efficiency. A well known material is tris(8-quinolinato) aluminum (Alq) which produces excellent green electroluminescence.

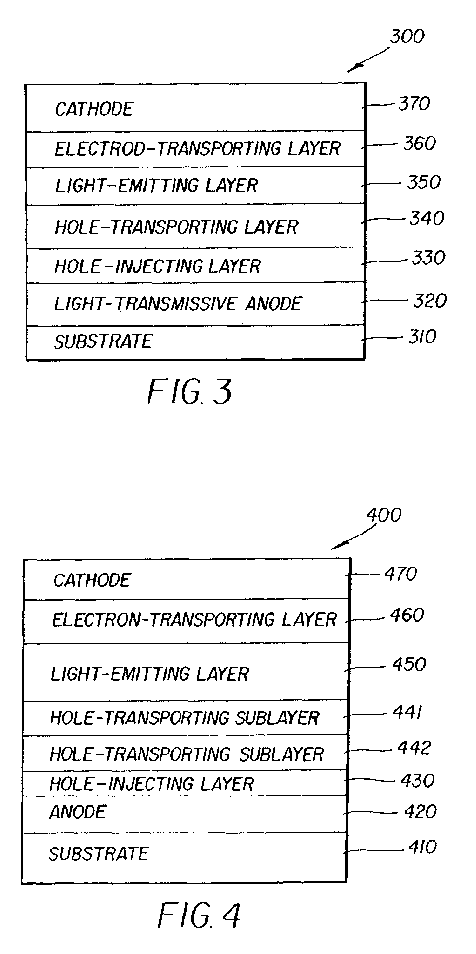

The simple structure can be modified to a three-layer structure (device 200) as shown in FIG. 2, in which an additional electroluminescent layer is introduced between the hole- and electron-transporting layers to function primarily as the site for hole-electron recombination and thus electroluminescence. In this respect, the functions of the individual organic layers are distinct and can therefore be optimized independently. Thus, the electroluminescent or recombination layer can be chosen to have a desirable OLED color as well as high luminance efficiency. Likewise, the electron and hole-transporting layers can be optimized primarily for the carrier transport property. It will be understood to those skilled in the art that the electron-transporting layer and the cathode can be made to be transparent, facilitating illumination of the device through its top layer and not through the substrate.

Turning to FIG.2, an organic light-emitting device 200 has a light-transmissive substrate 210 on which is disposed a light-transmissive anode 220. An organic light-emitting structure is formed between the anode 220 and a cathode 270. The organic light-emitting structure is comprised of, in sequence, an organic hole-transporting layer 240 (HTL), an organic light-emitting layer 250, and an organic electron-transporting layer (ETL) 260. Layer 230 is a hole-injecting layer (HIL). When an electrical potential difference (not shown) is applied between the anode 220 and the cathode 270, the cathode will inject electrons into the electron-transporting layer 260 and the electrons will migrate across layer 260 to the light-emitting layer 250. At the same time, holes will be injected from the anode 220 into the hole-transporting layer 240. The holes will migrate across layer 240 and recombine with electrons at or near a junction formed between the hole-transporting layer 240 and the light-emitting layer 250. When a migrating electron drops from its conduction band to a valance band in filling a hole, energy is released as light, and which is emitted through the light-transmissive anode 220 and substrate 210.

The organic OLED devices can be viewed as a diode, which is forward biased when the anode is at a higher potential than the cathode. The anode and cathode of the organic OLED device can each take any convenient conventional form, such as any of the various forms disclosed by Tang and others in US-A-4,885,211. Operating voltage can be substantially reduced when using a low-work function cathode and a high-work function anode. The preferred cathodes are those constructed of a combination of a metal having a work function less than 4.0 eV and one other metal, preferably a metal having a work function greater than 4.0 eV. The Mg:Ag of Tang and others US-A-4,885,211 constitutes one preferred cathode construction. The Al:Mg cathodes of Van Slyke and others US-A-5,059,062 is another preferred cathode construction. Hung and others in US-A-5,776,622 has disclosed the use of a LiF/Al bilayer to enhanced electron injection in organic OLED devices. Cathodes made of either Mg:Ag, Al:Mg or LiF/Al are opaque and displays cannot be viewed through the cathode. Recently, a series of publications by Gu and others in APL 68, 2606 (1996); Burrows and others, J. Appl. Phys. 87, 3080 (2000); Parthasarathy and others APL 72, 2138 9198); Parthasarathy and others APL 76, 2128 (2000); and Hung and others APL, 3209 (1999) have disclosed transparent cathodes. These transparent cathodes are based on the combination of a thin semitransparent metal (~10 nm) and indium-tin-oxide (ITO) on top of the metal. An organic layer of copper phthalocyanine (CuPc) also replaced thin metal.

Conventionally, anode 220 is formed of a conductive and transparent oxide. Indium tin oxide has been widely used as the anode contact because of its transparency, good conductivity, and high-work function.

In a preferred embodiment, an anode 220 can be modified with a hole-injecting layer 230. The hole-injecting material can serve to improve the film formation property of subsequent organic layers and to facilitate injection of holes into the hole-transporting layer. Suitable materials for use in the hole-injecting layer include, but are not limited to, porphyrinic compounds such as CuPC as described in US-A-4,720,432, and plasma-deposited fluorocarbon polymers as described in US-A-6,208,075. and some aromatic amines, for example,
m-MTDATA (4,4',4"-tris[(3-methylphenyl)phenylamino]triphenylamine). Alternative hole-injecting materials reportedly useful in organic EL devices are described in EP 0 891 121 A1 and EP 1 029 909 A1. An example of material in such a hole-injecting layer are the fluorocarbons disclosed by Hung and others in US-A-6,208,075.

The OLED device of this invention is typically provided over a supporting substrate 210 where either the cathode or anode can be in contact with the substrate. The electrode in contact with the substrate is conveniently referred to as the bottom electrode. Conventionally, the bottom electrode is the anode, but this invention is not limited to that configuration. The substrate can either be light-transmissive or opaque, depending on the intended direction of light emission. The light-transmissive property is desirable for viewing the EL emission through the substrate. Transparent glass or plastic is commonly employed in such cases. For applications where the EL emission is viewed through the top electrode, the transmissive characteristic of the bottom support is immaterial, and therefore can be light-transmissive, light absorbing or light reflective. Substrates for use in this case include, but are not limited to, glass, plastic, semiconductor materials, silicon, ceramics, circuit board materials, and polished metal surface. Of course, it is necessary to provide in these device configurations a light-transparent top electrode.

The white OLED emission can be used to prepare a full-color device using red, green, and blue (R, G, B) color filters. The R, G, B filters may be deposited on the substrate (when light transmission is through the substrate), incorporated into the substrate, or deposited over the top electrode (when light transmission is through the top electrode). When depositing a R, G, B filter array over the top electrode, a buffer layer may be used to protect the top electrode. The buffer layer may comprise inorganic materials, for example, silicon oxides and nitrides, or organic materials, for example, polymers, or multiple layers of inorganic and organic materials. Methods for providing R, G, B filter arrays are well known in the art. Lithographic means, inkjet printing, and laser thermal transfer are just a few of the methods by which R, G, B filters may be provided.

This technique of producing a full-color display using white light plus R, G, B filters has several advantages over the precision shadow masking technology used for producing full-color displays. This technique does not require precision alignment, is low cost and easy to manufacture. The substrate itself contains thin film transistors to address the individual pixels. US-A-5,550,066 and US-A-5,684,365 to Ching and others describe the addressing methods of the TFT substrates.

The hole-transporting layer contains at least one hole-transporting compound such as an aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. Exemplary monomeric triarylamines are illustrated by Klupfel and others US-A-3,180,730. Other suitable triarylamines substituted with one or more vinyl radicals and/or comprising at least one active hydrogen containing group are disclosed by Brantley and others US-A-3,567,450 and US-A-3,658,520.

A more preferred class of aromatic tertiary amines are those which include at least two aromatic tertiary amine moieties as described in US-A-4,720,432 and US-A-5,061,569. The hole-transporting layer can be formed of a single or a mixture of aromatic tertiary amine compounds set forth in Table 1. Illustrative of useful aromatic tertiary amines is the following list. In accordance with the present invention, these materials can also be used as dopants in the blue light-emitting layer and, for the purpose of this disclosure, will be called blue stabilizing hole-transporting materials.

**Table 1**

| |
|---|
| 1,1-Bis(4-di-*p*-tolylaminophenyl)cyclohexane |
| 1,1-Bis(4-di-*p*-tolylaminophenyl)-4-pbenylcyclohexane |
| 4,4'-Bis(diphenylamino)quadriphenyl |
| Bis(4-dimethylamino-2-methylphenyl)-phenylmethane |
| N,N,N-Tri(*p*-tolyl)amine |
| 4-(di-p-tolylamino)-4'-[4(di-*p*-tolylamino)-styryl]stilbene |
| N,N,N',N'-Tetra-*p*-tolyl-4-4'-diaminobiphenyl |
| N,N,N',N'-Tetraphenyl-4,4'-diaminobiphenyl |
| N,N,N',N'-tetra-1-naphthyl-4,4'-diaminobiphenyl |
| N,N,N',N'-tetra-2-naphthyl-4,4'-diaminobiphenyl |
| N-Phenylcarbazole |
| 4,4'-Bis[N-(1-naphthyl)-N-phenylamino]biphenyl (NPB) |
| 4,4'-Bis[N-(1-naphthyl)-N-(2-naphthyl)amino]biphenyl (TNB) |
| 4,4"-Bis[N-(1-naphthyl)-N-phenylamino]p-terphenyl |
| 4,4'-Bis[N-(2-naphthyl)-N-phenylamino]biphenyl |
| 4,4'-Bis[N-(3-acenaphthenyl)-N-phenylamino]biphenyl |
| 1,5-Bis[N-(1-naphthyl)-N-phenylamino]naphthalene |
| 4,4'-Bis[N-(9-anthryl)-N-phenylamino]biphenyl |
| 4,4"-Bis[N-(1-anthryl)-N-phenylamino]-*p*-terphenyl |
| 4,4'-Bis[N-(2-phenanthryl)-N-phenylamino]biphenyl |
| 4,4'-Bis[N-(8-fluoranthenyl)-N-phenylamino]biphenyl |
| 4,4'-Bis[N-(2-pyrenyl)-N-phenylamino]biphenyl |
| 4,4'-Bis[N-(2-naphthacenyl)-N-phenylamino]biphenyl |
| 4,4'-Bis[N-(2-perylenyl)-N-phenylamino]biphenyl |
| 4,4'-Bis[N-(1-coronenyl)-N-phenylamino]biphenyl |
| 2,6-Bis(di-*p*-tolylamino)naphthalene |
| 2,6-Bis[di-(1-naphthyl)amino]naphthalene |
| 2,6-Bis[N-(1-naphthyl)-N-(2-naphthyl)amino]naphthalene |
| N,N,N',N'-Tetra(2-naphthyl)-4,4"-diamino-*p*-terphenyl |
| 4,4'-Bis{N-phenyl-N-[4-(1-naphthyl)-phenyl]amino}biphenyl |
| 4,4'-Bis[N-phenyl-N-(2-pyrenyl)amino]biphenyl |
| 2,6-Bis[N,N-di(2-naphthyl)amine]fluorene |
| 1,5-Bis[N-(1-naphthyl)-N-phenylamino]naphthalene |
| 4,4',4"-tris[(3-methylphenyl)phenylamino]triphenylamine (MTDATA) |
| 4,4'-Bis[N-(3-methylphenyl)-N-phenylamino]biphenyl (TPD) |

Another class of useful hole-transporting materials includes polycyclic aromatic compounds as described in EP 1 009 041. Tertiary aromatic amines with more than two amine groups may be used including oligomeric materials. In addition, polymeric hole-transporting materials can be used such as poly(N-vinylcarbazole) (PVK), polythiophenes, polypyrrole, polyaniline, and copolymers such as poly(3,4-ethylenedioxythiophene)/poly(4-styrenesulfonate) also called PEDOT/PSS.

Preferred materials for use in forming the electron-transporting layer of the organic OLED devices of this invention are metal chelated oxinoid compounds, including chelates of oxine itself (also commonly referred to as 8-quinolinol or 8-hydroxyquinoline) as disclosed in US-A-4.885,211. Tris(8-quinolinolato)aluminum(III) also commonly known as Alq is one of the commonly used electron-transporting materials. Such compounds exhibit high levels of performance and are readily fabricated in the form of thin layers. Some examples of useful electron-transporting materials are:
Aluminum trisoxine [alias, tris(8-quinolinolato)aluminum(III)]
Magnesium bisoxine [alias, bis(8-quinolinolato)magnesium(II)]
Bis[benzo {f} -8-quinolinolato]zinc (II)
Bis(2-methyl-8-quinolinolato)aluminum(III)-µ-oxo-bis(2-methyl-8-quinolinolato) aluminum(III)
Indium trisoxine [alias, tris(8-quinolinolato)indium]
Aluminum tris(5-methyloxine) [alias, tris(5-methyl-8-quinolinolato) aluminum(III)]
Lithium oxine [alias, (8-quinolinolato)lithium(I)]
Gallium oxine [alias, tris(8-quinolinolato)gallium(III)]
Zirconium oxine [alias, tetra(8-quinolinolato)zirconium(IV)]

Other electron-transporting materials include various butadiene derivatives as disclosed in US-A-4,356,429 and various heterocyclic optical brighteners as described in US-A-4,539,507. Benzazoles and triazines are also useful electron-transporting materials.

Another material of the series, BAlq, has been used as an electron-transporting material. US-A-5,141,671 issued to Bryan and others discusses such materials. The BAlq is comprised of a mixed ligand aluminum chelate, specifically a bis(Rs-8-quinolinolato)(phenolato)aluminum(II) chelate, where Rs is a ring substituent of the 8-quinolinolato ring nucleus. These compounds are represented by the formula Rs-Q2-Al-O-L where Q in each occurrence represents a substituted 8-quinolinolato ligand, Rs represents an 8-quinolinolato ring substituent to block sterically the attachment of more than two substituted 8-quinolinolato ligand to the aluminum atom, O-L is phenolatoligand, and L is a hydrocarbon of from 6 to 24 carbon atoms comprised of phenyl moiety. One such compound, particularly ((1,1'-biphenyl)-4-olato)bis(2-methyl-8-quinolinoato N1,O8)aluminum, has been used as a hole blocking material by T. Watanabe and others, Proceedings of SPIE Vol. 4105 (2001), p. 175-182.

A preferred embodiment of the luminescent layer consists of a host material doped with fluorescent dyes. Using this method, highly efficient EL devices can be constructed. Simultaneously, the color of the EL devices can be tuned by using fluorescent dyes of different emission wavelengths in a common host material. Tang and others in commonly assigned US-A-4,769,292 has described this dopant scheme in considerable detail for EL devices using Alq as the host material.

Shi and others in commonly assigned US-A-5,935,721 have described this dopant scheme in considerable detail for the blue emitting OLED devices using 9,10-di-(2-naphthyl)anthracene (ADN) derivatives as the host material.

Derivatives of 9,10-di-(2-naphthyl)anthracene (Formula 1) constitute one class of useful hosts capable of supporting electroluminescence, and are particularly suitable for light emission of wavelengths longer than 400 nm, for example, blue, green, yellow, orange, or red. 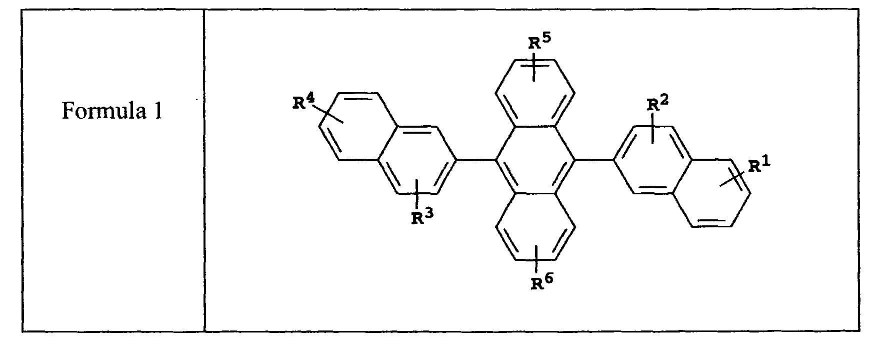 wherein R₁, R₂, R₃, R₄, R₅, R₆ represent one or more substituents on each ring where each substituent is individually selected from the following groups:
Group 1: hydrogen, or alkyl of from 1 to 24 carbon atoms;
Group 2: aryl or substituted aryl of from 5 to 20 carbon atoms;
Group 3: carbon atoms from 4 to 24 necessary to complete a fused aromatic ring of naphthyl, anthracenyl; phenanthryl, pyrenyl, or perylenyl;
Group 4: heteroaryl or substituted heteroaryl of from 5 to 24 carbon atoms such as thiazolyl, furyl, thienyl, pyridyl, quinolinyl or other heterocyclic systems, which may be bonded via a single bond, or may complete a fused heteroaromatic ring system;
Group 5: alkoxylamino, alkylamino, or arylamino of from 1 to 24 carbon atoms; or
Group 6: fluorine, chlorine, bromine or cyano.

Illustrative examples include 9,10-di-(2-naphthyl)anthracene (ADN) and 2-*t*-butyl-9,10-di-(2-naphthyl)anthracene (TBADN). Other anthracene derivatives can be useful as a host in the LEL, such as diphenylanthracene and its derivatives, as described in US-A-5,927,247. Styrylarylene derivatives as described in US-A-5,121,029 and JP 08333569 are also useful hosts for blue emission. For example, 9,10-bis[4-(2,2-diphenylethenyl)phenyl]anthracene and 4,4'-Bis(2,2-diphenylethenyl)-1,1'-biphenyl (DPVBi) are useful hosts for blue emission.

Many blue fluorescent dopants are known in the art, and are contemplated for use in the practice of this invention. Particularly useful classes of blue-emitting dopants include perylene and its derivatives such as 2,5,8,11-tetra-tert-butyl perylene (TBP), and distyrylamine derivatives as described in US-A-5,121,029, such as B1 (structure shown below) 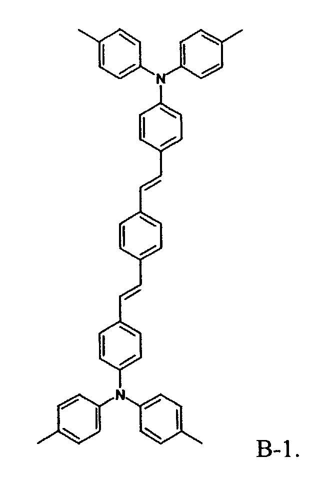 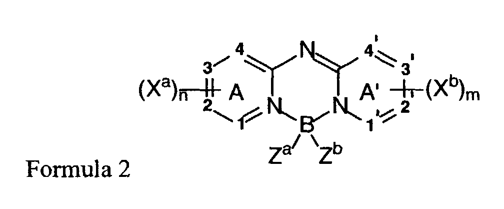 wherein:
A and A' represent independent azine ring systems corresponding to 6-membered aromatic ring systems containing at least one nitrogen;
each X^{a} and X^{b} is an independently selected substituent, two of which may join to form a fused ring to A or A';
m and n are independently 0 to 4 ;
Z^{a} and Z^{b} are independently selected substituents; and
1, 2, 3, 4, 1', 2', 3', and 4' are independently selected as either carbon or nitrogen atoms.

Desirably, the azine rings are either quinolinyl or isoquinolinyl rings such that 1, 2, 3, 4, 1', 2', 3', and 4' are all carbon; m and n are equal to or greater than 2; and X^{a} and X^{b} represent at least two carbon substituents which join to form an aromatic ring. Desirably, Z^{a} and Z^{b} are fluorine atoms.

Preferred embodiments further include devices where the two fused ring systems are quinoline or isoquinoline systems; the aryl or heteroaryl substituent is a phenyl group; there are present at least two X^{a} groups and two X^{b} groups which join to form a 6-6 fused ring, the fused ring systems are fused at the 1-2, 3-4, 1'-2', or 3'-4' positions, respectively; one or both of the fused rings is substituted by a phenyl group; and where the dopant is depicted in Formula 3, 4, or 5. 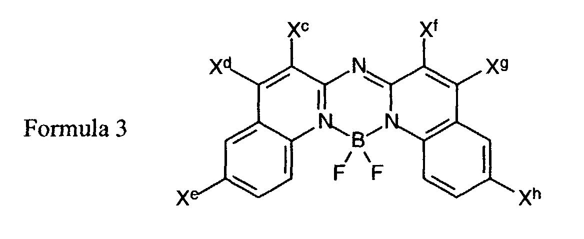 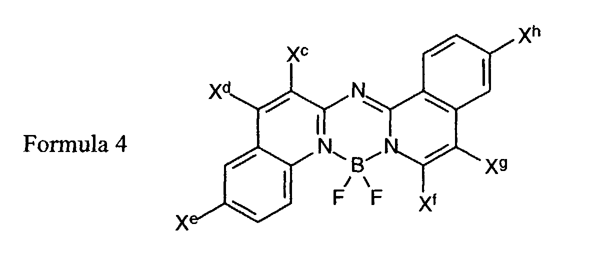 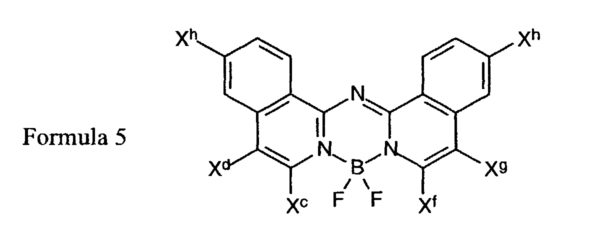 wherein each X^{c}, X^{d}, X^{e}, X^{f}, X^{g}, and X^{h} is hydrogen or an independently selected substituent, one of which must be an aryl or heteroaryl group.

Desirably, the azine rings are either quinolinyl or isoquinolinyl rings such that 1, 2, 3, 4, 1', 2', 3', and 4' are all carbon; m and n are equal to or greater than 2; and X^{a} and X^{b} represent at least two carbon substituents which join to form an aromatic ring, and one is an aryl or substituted aryl group. Desirably, Z^{a} and Z^{b} are fluorine atoms.

Illustrative, non-limiting examples of boron compounds complexed by two ring nitrogens of a deprotonated bis(azinyl)amine ligand, wherein the two ring nitrogens are members of different 6,6 fused ring systems in which at least one of the systems contains an aryl or heteroaryl substituent, useful in the present invention are the following: 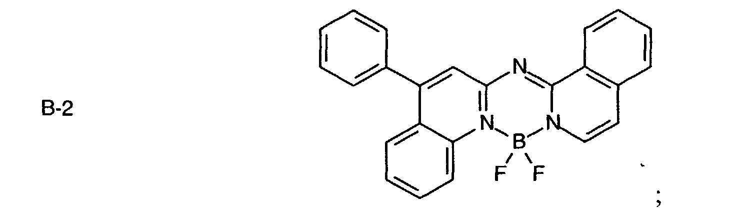 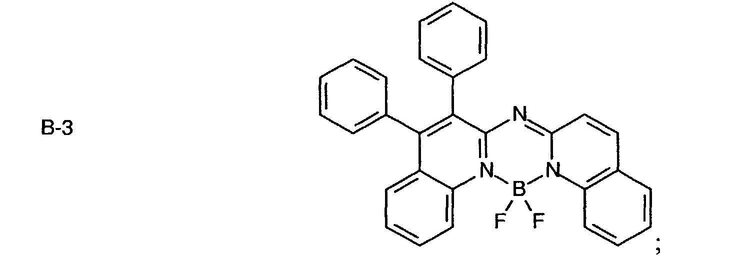 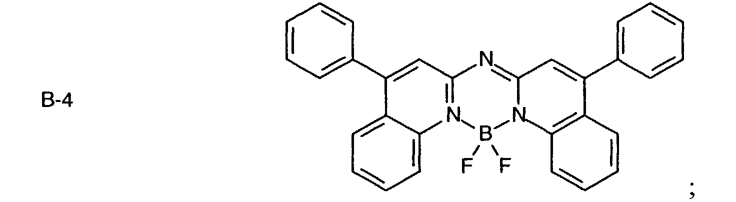 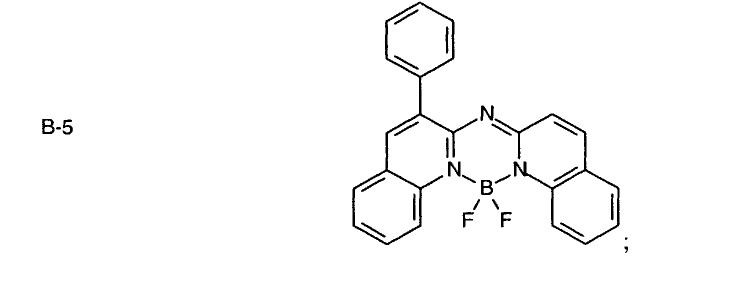 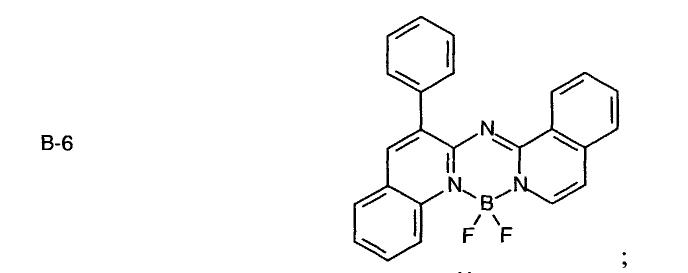 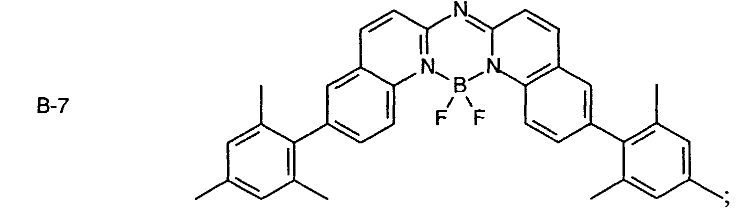 and

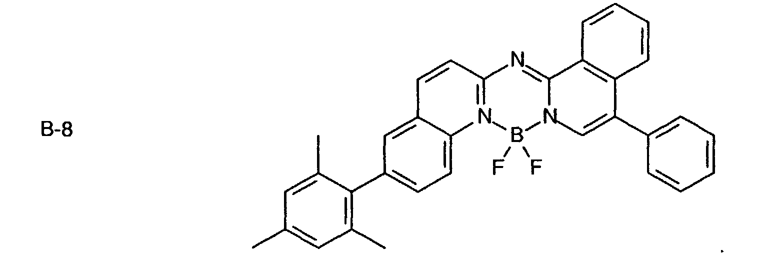

Preferred materials for uses as a yellow-emitting dopant in the hole-transporting or electron-transporting layers are those represented by Formula 6. 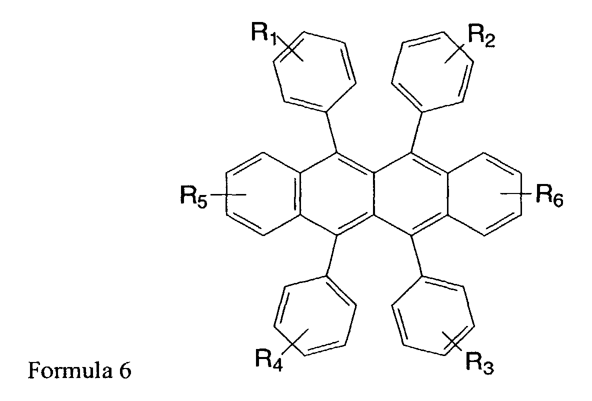 wherein R₁, R₂, R₃, and R₄ represent one or more substituents on each ring where each substituent is individually selected from the following groups:
Group 1: hydrogen, or alkyl of from 1 to 24 carbon atoms;
Group 2: aryl or substituted aryl of from 5 to 20 carbon atoms;
Group 3: carbon atoms from 4 to 24 necessary to complete a fused aromatic ring of phenyl, naphthyl, anthracenyl; phenanthryl, pyrenyl, or perylenyl;
Group 4: heteroaryl or substituted heteroaryl of from 5 to 24 carbon atoms such as thiazolyl, furyl, thienyl, pyridyl, quinolinyl or other heterocyclic systems, which may be bonded via a single bond, or may complete a fused heteroaromatic ring system;
Group 5: alkoxylamino, alkylamino, or arylamino of from 1 to 24 carbon atoms; or
Group 6: fluorine, chlorine, bromine or cyano.
R₅ and R₆ are defined in the same way as R₁ - R₄ except that they do not form a fused ring.

Further, at least one of R₁ - R₄ must be substituted with a group. Preferred groups for substitution on R₁ - R₄ are Groups 3 and 4.

Examples of particularly useful yellow dopants include 5,6,11,12-tetraphenylnaphthacene (rubrene); 6,11-diphenyl-5,12-bis(4-(6-methylbenzothiazol-2-yl)phenyl)naphthacene (DBzR); and 5,6,11,12-tetra(2-naphthyl)naphthacene (NR), the formulas of which are shown below: 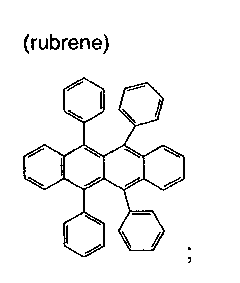 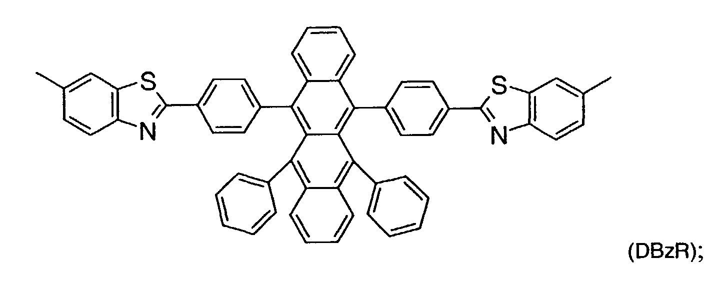 and

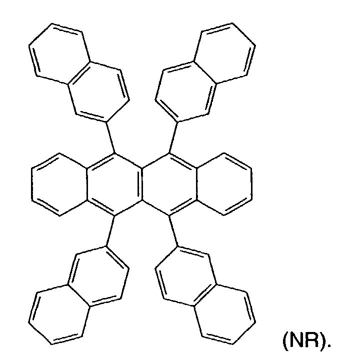

Coumarins represent a useful class of green-emitting dopants as described by Tang and others in US-A-4,769,292 and 6,020,078. Examples of useful green-emitting coumarins include C545T and C545TB. Quinacridones represent another useful class of green-emitting dopants. Useful quinacridones are described in US-A-5,593,788, and Publication JP 09-13026A.

Examples of particularly useful green-emitting quinacridones are shown below: 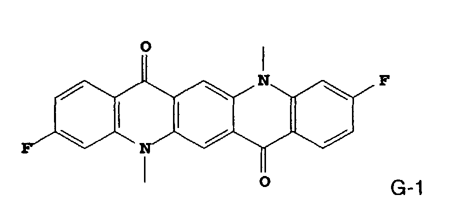 ; and

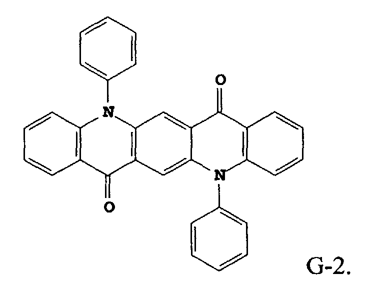

Another useful class of green-emitting dopants is represented by Formula 7 below.

Compounds useful in the invention are suitably represented by Formula 7: 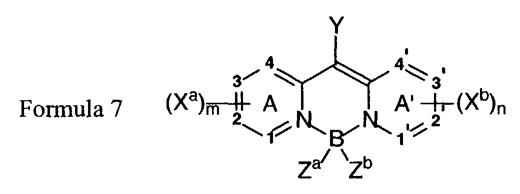 wherein:
A and A' represent independent azine ring systems corresponding to 6-membered aromatic ring systems containing at least one nitrogen;
each X^{a} and X^{b} is an independently selected substituent, two of which may join to form a fused ring to A or A';
m and n are independently 0 to 4;
Y is H or a substituent;
Z^{a} and Z^{b} are independently selected substituents; and
1, 2, 3, 4, 1', 2', 3', and 4' are independently selected as either carbon or nitrogen atoms.

In the device, 1, 2, 3, 4, 1', 2', 3', and 4' are conveniently all carbon atoms. The device may desirably contain at least one or both of ring A or A' that contains substituents joined to form a fused ring. In one useful embodiment, there is present at least one X^{a} or X^{b} group selected from the group consisting of halide and alkyl, aryl, alkoxy, and aryloxy groups. In another embodiment, there is present a Z^{a} and Z^{b} group independently selected from the group consisting of fluorine and alkyl, aryl, alkoxy and aryloxy groups. A desirable embodiment is where Z^{a} and Z^{b} are F. Y is suitably hydrogen or a substituent such as an alkyl, aryl, or heterocyclic group.

The emission wavelength of these compounds may be adjusted to some extent by appropriate substitution around the central bis(azinyl)methene boron group to meet a color aim, namely green. Some examples of useful formulas follow: 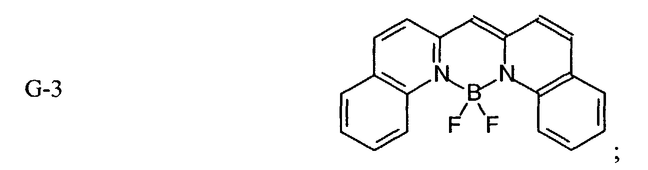 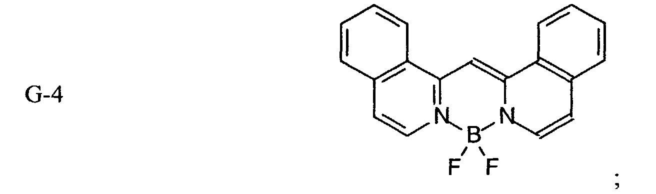 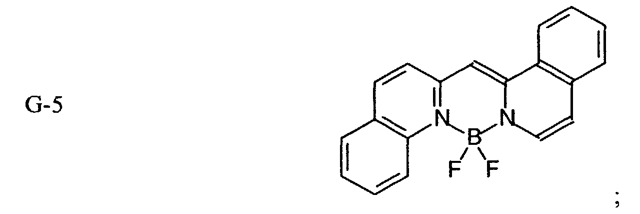 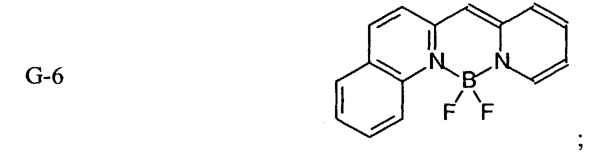 and

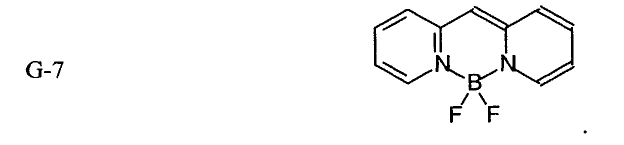

The invention and its advantages are further illustrated by the specific examples that follow. The term "percentage" indicates the volume percentage (or a thickness ratio as measured on the thin film thickness monitor) of a particular dopant with respect to the host material.

FIGS. 3-14 show schematics of the white light producing OLED device structure that have been made in accordance with the present invention and graphs of various parameters of their operations. The invention and its advantages are further illustrated by the specific examples that follow.

Turning to FIG. 3, an organic white light-emitting device 300 has a light-transmissive substrate 310 on which is disposed a light-transmissive anode 320. An organic white light-emitting structure 300 is formed between the anode 320 and a cathode 370. The organic light-emitting structure is comprised of, in sequence, a hole-injecting layer 330, and an organic hole-transporting layer 340, which is doped with yellow-emitting dopants. An organic light-emitting layer 350 is a blue light-emitting layer comprising TBADN host, B-1 dopant, and co-dopants selected from a group of NPB, Alq, and BAlq. An organic electron-transporting layer 360 is made of Alq.

FIG. 4 depicts an organic white light-emitting device 400 which is similar to that shown in FIG. 3, except that the organic hole-transporting layer comprises two sublayers, layers 441 and layer 442. Layer 442 is made of undoped NPB and the layer 441, which is adjacent to the blue light-emitting layer 450, is doped with yellow-emitting dopant. Other layers of the structure 400 are substrate 410, anode 420, hole-injecting layer 430, electron-transporting layer 460, and cathode 470.

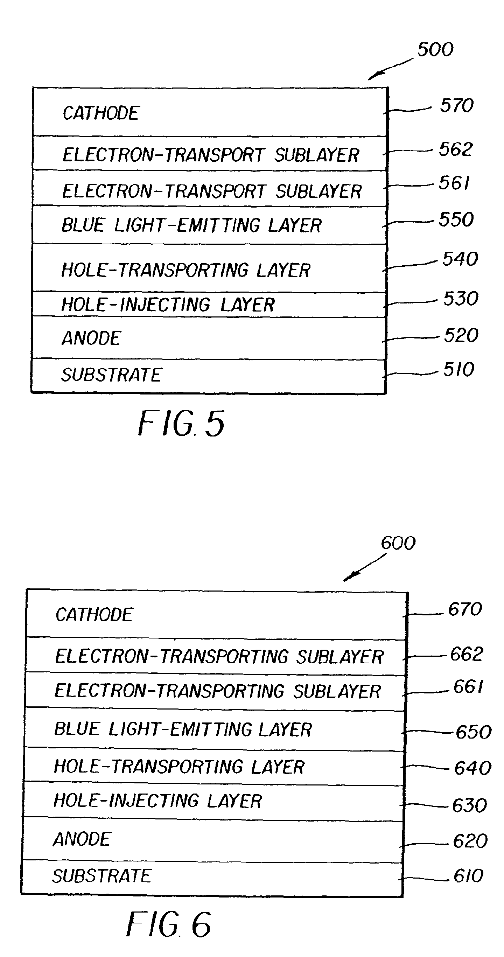

FIG. 5 depicts an organic white light-emitting device 500. The electron-transporting layer comprises two sublayers, 561 and 562. Electron-transporting sublayer 561 is doped with the yellow-emitting dopant. Electron-transporting sublayer 562 is not doped with a light-emitting dopant. The blue light-emitting layer 550 comprises TBADN host, B-1 dopant, and co-dopants selected from a group of NPB, Alq, and BAlq. Other layers of the structure 500 are substrate 510, anode 520, hole-injecting layer 530, hole transport layer 540 and cathode 570.

FIG. 6 depicts an organic white light-emitting device 600, which is a combination of structure 300 and structure 500. The hole-transporting layer 640 is doped with a yellow-emitting dopant. The electron-transporting layer comprises two electron-transporting sublayers, 661 and 662, and sublayer 661 is doped with a yellow-emitting dopant. The blue light-emitting layer 650 is made of TBADN host, B-1 dopant, and co-dopants selected from a group of NPB, Alq, and BAlq. Other layers of structure 600 are substrate 610, anode 620, hole-injecting layer 630, electron-transporting layer 662, and cathode 670.

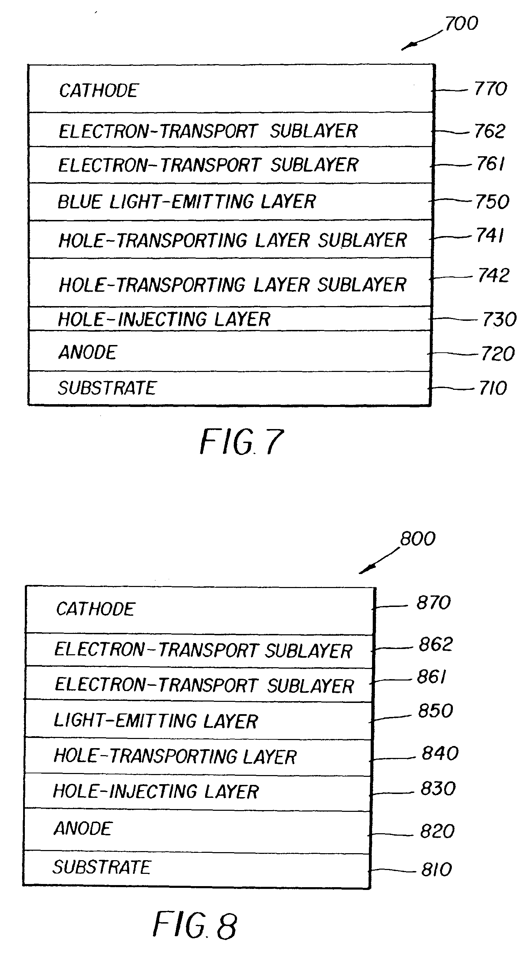

FIG. 7 depicts an organic white light-emitting device 700 which is similar to that shown in FIG. 6, except that the organic hole-transporting layer consists of two sublayers, sublayers 741 and 742. Sublayer 742 is made of undoped NPB, and sublayer 741, adjacent to the blue light-emitting layer 750, is doped with a yellow-emitting dopant. The electron-transporting layer comprises two sublayers, sublayers 761 and 762. Electron-transporting sublayer 761 is adjacent to the blue light-emitting layer 750, and is also doped with yellow-emitting dopant. Electron-transporting sublayer 762 is not doped with a light-emitting dopant. Other layers of structure 700 are substrate 710, anode 720, hole-injecting layer 730,and cathode 770.

FIG. 8 depicts an organic white light-emitting device 800 that is similar to that shown in FIG. 3, except that the electron-transporting layer comprises two sublayers, 861 and 862. Electron-transporting sublayer 861 comprises a green-emitting dopant such as C545T, CFDMQA, and DPQA, and sublayer 861 is adjacent to the blue light-emitting layer 850. Electron-transporting sublayer 862 is not doped with a light-emitting dopant. The blue light-emitting layer is 850 and consists of TBADN host, B-1 dopant and co-dopants selected from a group of NPB, Alq, and BAlq. The hole-transporting layer 840 is doped with a yellow-emitting dopant. Other layers of the structure 800 are substrate 810, anode 820, hole-injecting layer 830, and cathode 870.

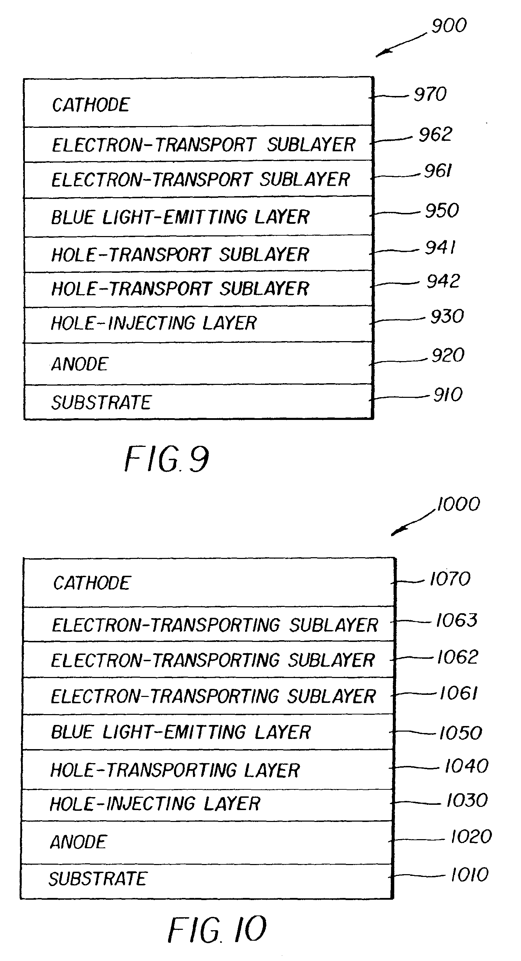

FIG. 9 depicts an organic white light-emitting device 900 which is similar to that shown in FIG. 8, except that the organic hole-transporting layer comprises two sublayers, 941 and 942. Hole-transporting sublayer 942 is made of undoped NPB, and sublayer 941 adjacent to the blue light-emitting layer 950 is doped with a yellow-emitting dopant. The electron-transporting layer comprises two sublayers, 961 and 962. The electron-transporting sublayer 961 is adjacent to the blue light-emitting layer 950, and comprises Alq doped with green dopants such as C545T, CFDMQA, and DPQA. Electron-transporting sublayer 962 is not doped with a light-emitting dopant. The blue light-emitting layer i950 consists of TBADN host, B-1 dopant and co-dopants selected from a group of NPB, Alq, and BAlq. Other layers of the structure 900 are substrate 910, anode 920, hole-injecting layer 930, and cathode 970.

FIG. 10 depicts an organic white light-emitting device 1000. Here, the electron-transporting layer comprises three sublayers 1061, 1062, and 1063. The electron-transporting sublayer 1061 is doped with a yellow-emitting dopant, and this layer is adjacent to the blue light-emitting layer 1050. Electron-transporting sublayer 1062 comprises a green-emitting dopant such as C545T, CFDMQA, or DPQA. Electron-transporting sublayer 1063 is not doped with a light-emitting dopant. The blue light-emitting layer 1050 can comprise TBADN host, B-1 dopant, and co-dopants selected from a group of NPB, Alq, and BAlq. Other layers of the structure 1000 are substrate 1010, anode 1020, hole-injecting layer 1030, hole-transporting layer 1040, and cathode 1070.

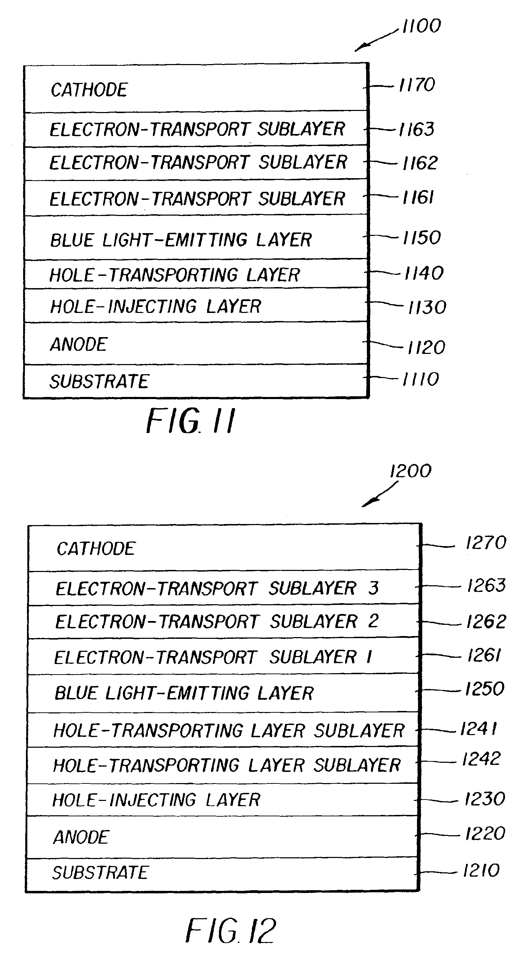

FIG. 11 depicts an organic white light-emitting device 1100. Here, the electron-transporting layer comprises three sublayers 1161, 1162, and 1163. The electron-transporting sublayer 1161 is doped with a yellow-emitting dopant, and this layer is adjacent to the blue light-emitting layer 1150. Electron-transporting sublayer 1162 comprises a green-emitting dopant such as C545T, CFDMQA, or DPQA. Electron-transporting sublayer 1163 is not doped with a light-emitting dopant. The blue light-emitting layer 1150 can comprise TBADN host, B-1 dopant, and co-dopants selected from a group of NPB, Alq, and BAlq. The hole-transporting layer 1140 is doped with a super rubrene yellow dopant. This device shows very high stability, high luminance efficiency, and good spectral radiance for all colors after the R, G, B color filters. Other layers of the structure 1100 are substrate 1110, anode 1120, hole-injecting layer 1130, and cathode 1170.

FIG. 12 depicts an organic white light-emitting device 1200. Here, the electron-transporting layer comprises three sublayers 1261, 1262, and 1263. The electron-transporting sublayer 1261 is doped with the yellow-emitting dopant, and this layer is adjacent to the blue light-emitting layer 1250. Electron-transporting sublayer 1262 comprises a green-emitting dopant such as C545T, CFDMQA, or DPQA. Electron-transporting sublayer 1263 is not doped with a light-emitting dopant. The blue light-emitting layer 1250 can comprise TBADN host, B-1 dopant, and co-dopants selected from a group of NPB, Alq, and BAlq. The hole-transporting layer comprises two sublayers, 1241 and 1242. Hole-transporting sublayer 1241 is undoped NPB. Hole-transporting sublayer 1242 is adjacent to blue light-emitting layer 1250, and is doped with a yellow-emitting dopant. Other layers of the structure 1200 are substrate 1210, anode 1220, hole-injecting layer 1230, and cathode 1170.

The invention and its advantages are further illustrated by the specific following examples.

Device Examples 1 to 6 given in Table 2 indicate the improvement in the luminance and stability performance of the white devices when the blue emitting layer is doped with an electron-transporting material such as Alq.

An OLED device was constructed in the following manner.

Substrates coated with 80 nm ITO were sequentially ultrasonicated in a commercial detergent, rinsed in deionized water, and degreased in toluene vapor. These substrates were treated with an oxygen plasma for about one minute and coated with one nm fluorocarbon layer by plasma assisted deposition of CHF₃. The same procedure was used for preparing all other devices described in this invention.

These substrates were loaded into a deposition chamber for organic layers and cathode depositions.

The device of Example 1 was prepared by following the structure of OLED 300 as shown in FIG. 3 by sequential deposition of 150 nm NPB hole-transporting layer (HTL) doped with 2% DBzR yellow dopant, 20 nm blue light-emitting layer (LEL) comprising TBADN host with 2% TBP blue dopant, 35 nm Alq electron-transporting layer (ETL), and then 200 nm MgAg cathode. The above sequence completed the deposition of the OLED device.

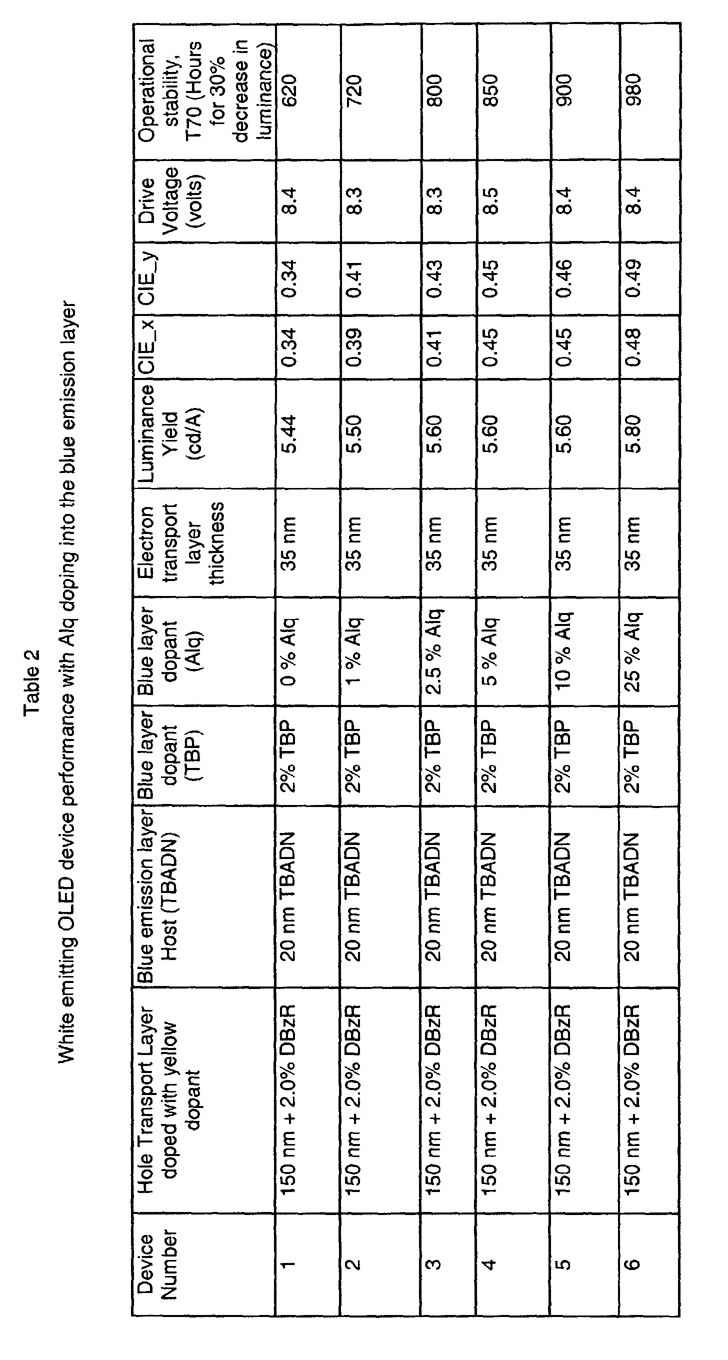

The OLED device was then "hermetically" packaged in a dry glove box filled with nitrogen for protection against ambient environment. The ITO patterned substrates used for preparing these OLED devices contained several test patterns. Each of the devices was tested for current voltage characteristics and the electroluminescence yield.

Devices of Examples 2 to 6 were prepared following structure of OLED 300 as shown in FIG. 3, and all the layers were similar except that the 20 nm (TBADN + 2% TBP) blue emitting layer was doped with varying amounts of Alq concentrations varying from 1% to 25%. It was found that the devices of Examples 2 to 6 show an increase in luminance efficiency and an increase in the operational stability of the devices. However, the original white color of the device was shifted to the higher wavelength (and was more on the orange side). Device Example 1 shows the CIEx,y color coordinates of (0.34, 0.34), whereas device Example 3 with 2.5% Alq in the blue emitting layer has CIEx,y equal to (0.41, 0.43).

It was found that co-doping NPB and Alq could reduce this shift in the color of the spectra into the blue emitting layer along with the blue-emitting dopant. Simultaneously, the device luminance efficiency and the operational stability were improved. The operational stability of the encapsulated OLED devices in ambient environments was found by measuring the changes in the drive voltage and the luminance as a function of time when OLED devices were operated at a constant current density of 20 mA/cm².

Devices of Examples 7 to 10 given in Table 3 show the improvement from co-doping Alq and NPB dopants in blue OLED devices. Device Example 7 was prepared with the layer structure: 150 nm NPB HTL/20 nm A_DN host + 2% TBP dopant as the blue emitting layer/25 nm Alq ETL/200 nm MgAg cathode. It has luminance efficiency of 3.35 cd/A, drive voltage 6.3 volts and CIEx,y = 0.16, 0.23 respectively. Device Example 8 was prepared similar to device Example 7, except that the blue emitting layer has 10% NPB as a co-dopant with TBP blue emitting dopant. It has luminance efficiency of 4.18 cd/A, drive voltage 6.2 volts, and CIEx,y = 0.16, 0.23, respectively. Thus, the efficiency of the device in Example 8 is higher than that of the device of Example 7. Device Example 9 was prepared similar to device Example 7, except that the blue emitting layer has 10% Alq as a co-dopant with TBP blue emitting dopant. It has luminance efficiency of 3.6 cd/A and CIEx,y = 0.23, 0.36, respectively. This efficiency is higher than that of device Example 7, however the color is shifted toward green. Device Example 10 was prepared similar to device Example 7, except that the blue emitting layer contained 10 % NPB and 10% Alq as co-dopants with TBP blue emitting dopant. It has luminance efficiency of 4.8 cd/A and CIEx,y = 0.20, 0.25, respectively. The luminance efficiency of the device in Example 10 is higher than that of the devices of Examples 7, 8, and 9, and the color is similar to that of the device Example 7. Thus, higher luminance efficiency and good color was obtained when both Alq and NPB co-dopants were doped in the blue emitting layer along with blue emitting dopant TBP. This blue light-emitting layer doped with blue dopant and the blue stabilizing dopant materials of device Example 10 can be used to make white emitting OLED devices using the structure shown in FIG. 3.

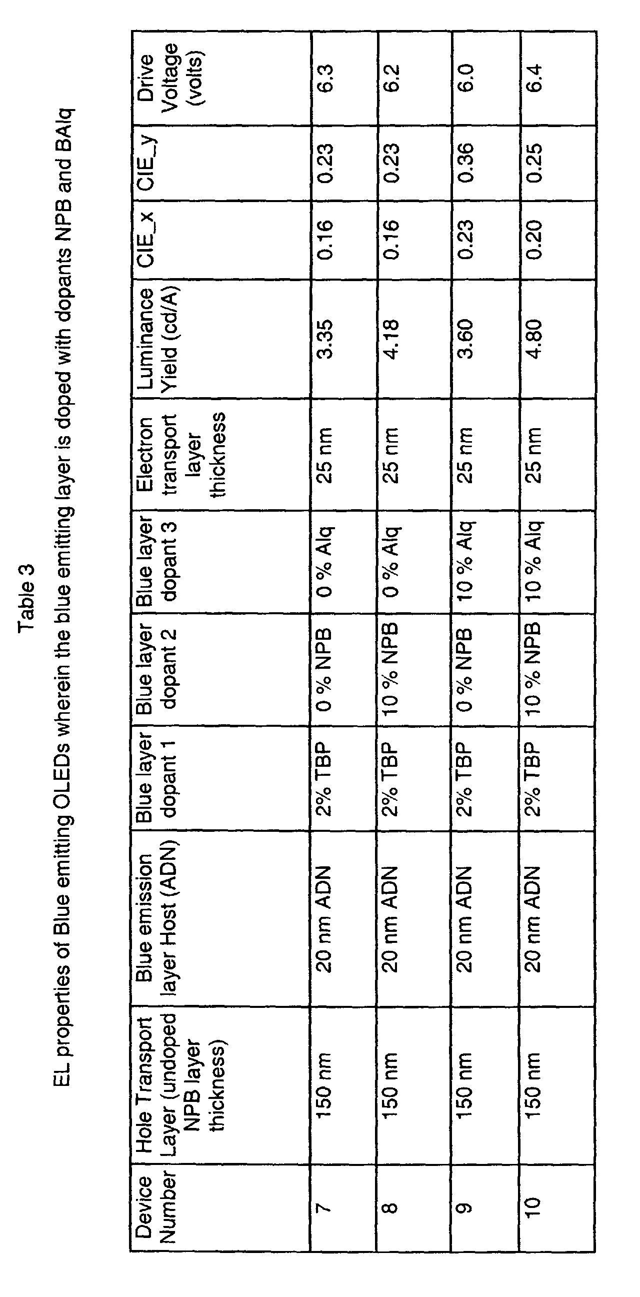

Device Examples 11 to 15 (Table 4): Table 4 describes the use of other blue stabilizing co-dopants, such as NPB and BAlq, in the blue light-emitting layer of the white light-emitting devices. NPB is the hole-transporting blue stabilizing dopant, and BAlq is the electron-transporting blue stabilizing dopant in the blue light-emitting layer.

The device of Example 11 was prepared by following the structure of OLED 300 as shown in FIG. 3. By sequential deposition of 130 nm undoped NPB hole-transporting layer (HTL), 20 nm NPB HTL doped with 2% rubrene yellow dopant, 15 nm blue light-emitting layer (LEL) comprising TBADN host with 5% OP31 blue dopant (blue dopant formula B-1 ), and 10% NPB co-dopant, 35 nm Alq electron-transporting layer (ETL), and then 0.5 nm LiF/200 nm aluminum as the cathode. The above sequence completed the deposition of the OLED device.

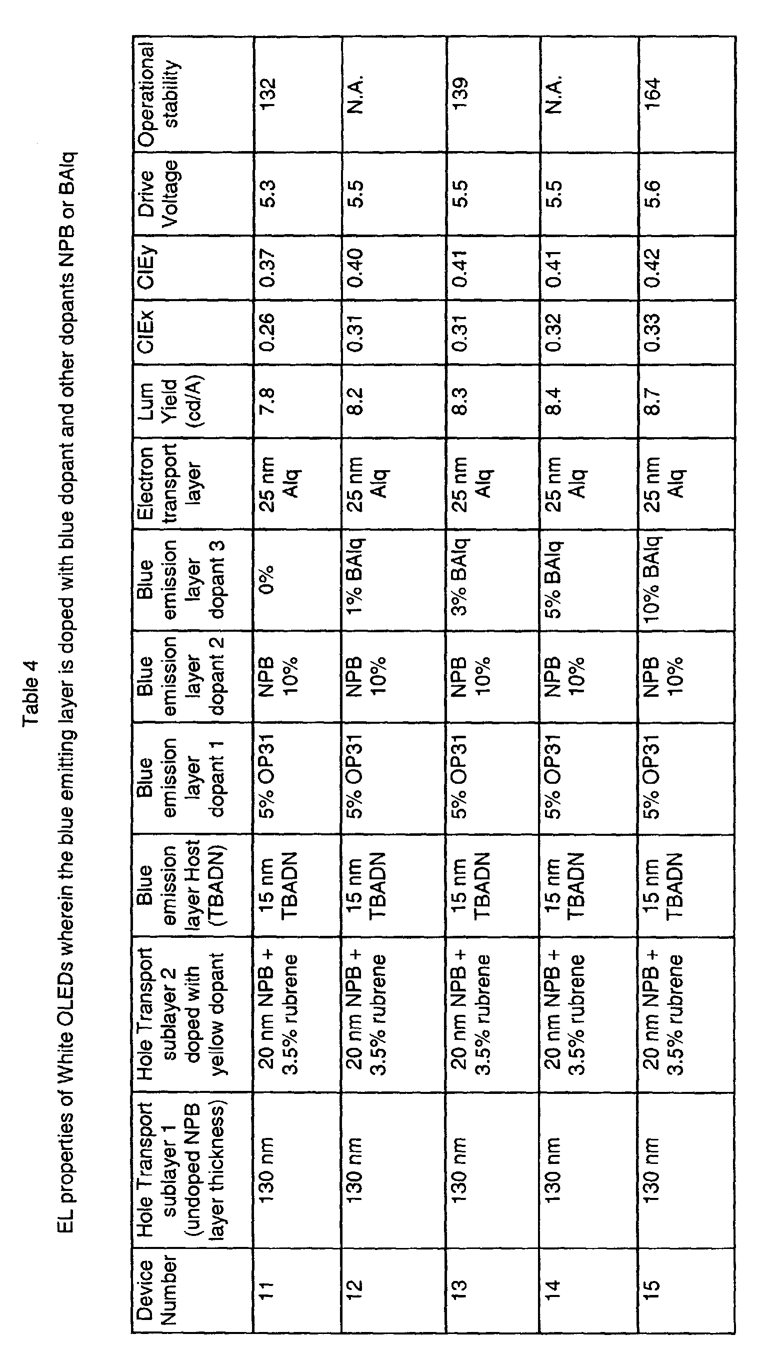

Devices of Examples 12 to 15 were prepared following the structure of OLED 300 as shown in FIG. 3. All the layers were similar to the device in Example 11 except that the 15 nm (TBADN + 5% OP31) blue emitting layer was co-doped with 10% NPB and varying amounts of BAlq concentrations varying from 1% to 10%. It was found that the devices of Example 12 to 15 show increased luminance efficiency and increased operational stability of the devices. The color of the white OLED was not significantly affected.

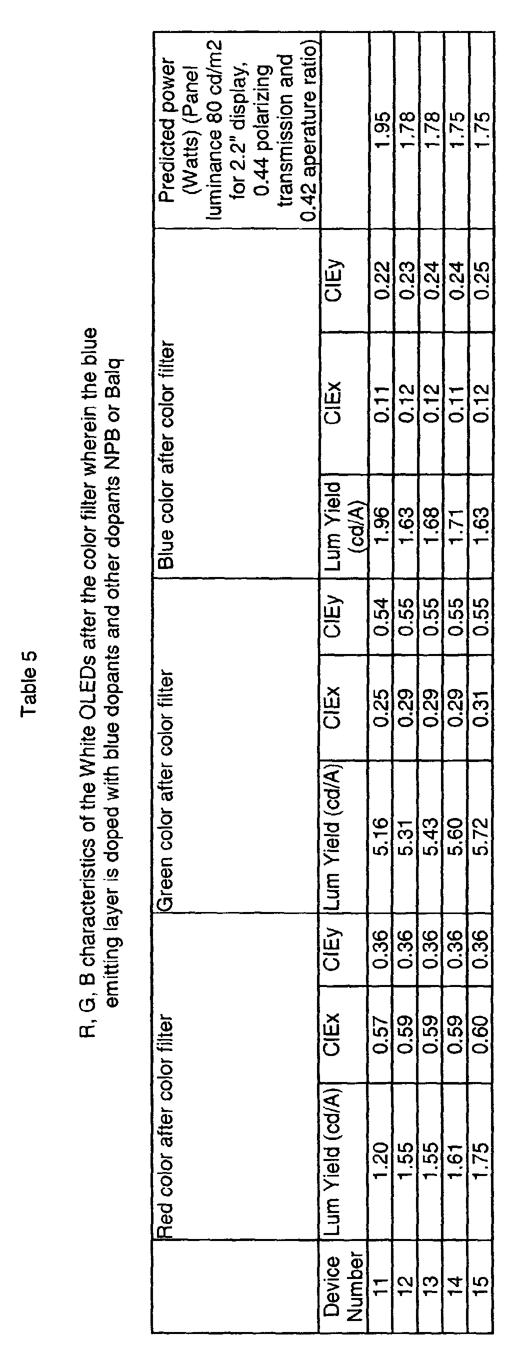

The luminance and the color data of the devices in Examples 11 to 15 given in Table 4 were used to predict the R, G, B color efficiency and the color when white light is passed through the R, G, B color filters. The power consumption on a 2.2" diagonal distance display was predicted at starting luminance of 80 cd/m2. It was found that the power consumption decreased from 1.95 watts to 1.75 watts. The stability of the device was simultaneously improved. This shows that the improvement in the luminance efficiency, reduction in power consumption, and improved lifetime was achieved by using NPB and BAlq co-dopants in the blue emitting layer along with a blue emitting dopant. Thus, white OLED devices can be prepared by following the different structures of this invention to have high performance and high operational stability.

Devices of Examples 16 to 21 were prepared following the structure of OLED 300 as shown in FIG. 3. Device Example 16 is a control. It has a glass substrate, 85 nm ITO anode, and 0.5 nm CFₓ hole injection layer. Thereafter, a 130 nm NPB layer was deposited as the hole transport layer followed by 20 nm NPB layer doped with 2% DBzR. Then was deposited a 20 nm blue EML consisting of a TBADN host and 2.5% blue dopant B1, followed by 25 nm Alq and cathode layers. This completed the device fabrication. The device was then encapsulated to protect it from moisture and environment. This device emitted white light. Device Examples 17 to 21 were prepared following the same procedure as control device Example 16, except that the blue emission layer had additional combinations of dopants as shown in Table 6. All of the layers for Devices 16 to 21 are the same except the blue emission layer. Device Examples 17 and 18 have a blue emission layer containing 5% and 10% Alq dopants along with the host and blue dopant B1. Device Example 19 has the blue emission layer containing 10% NPB dopant along with the host and blue dopant B1. Device Examples 20 and 21 have the emission layers, which contain both Alq and NPB co-dopants along with the host and blue dopant B 1.

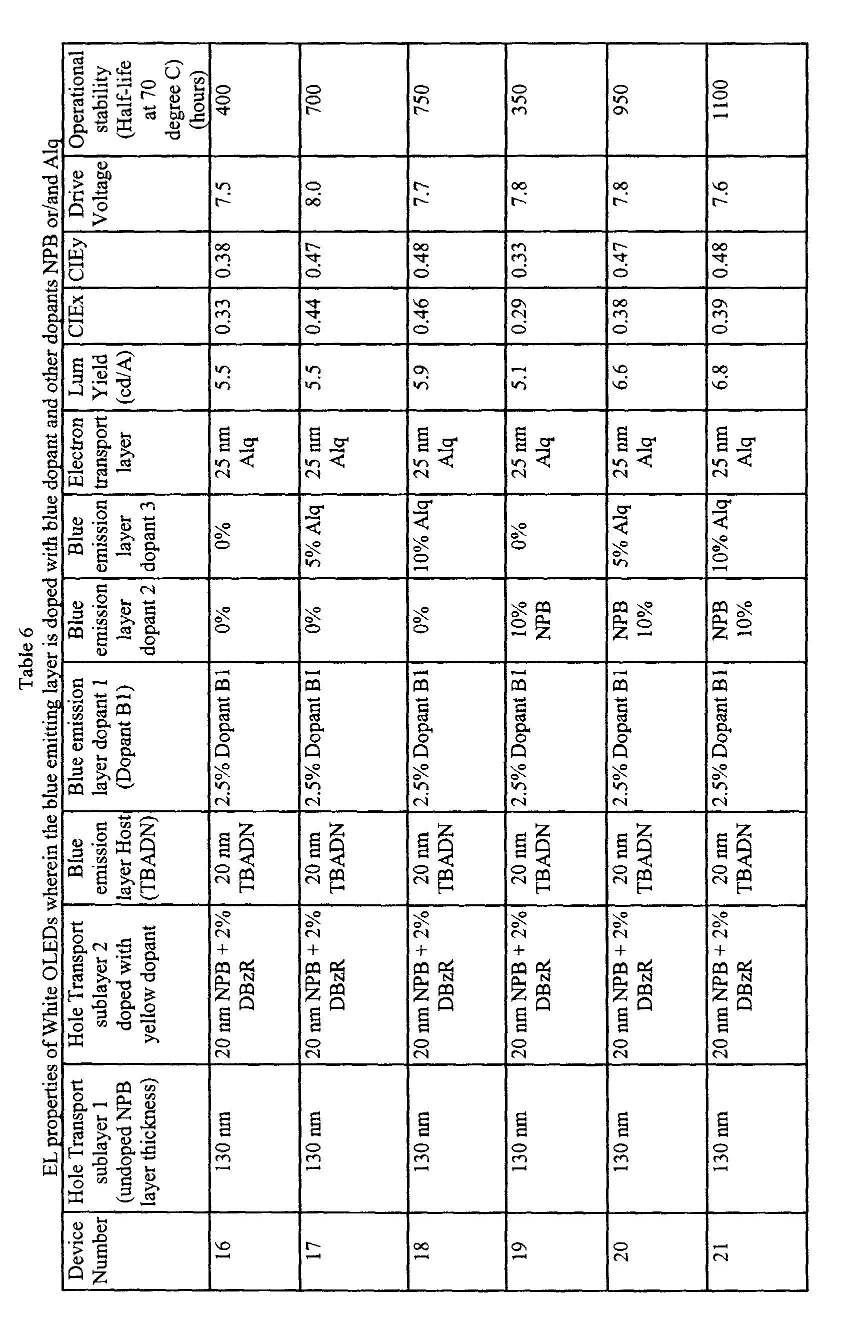

The luminance properties of the devices of Examples 16 to 21 are given in Table 6. The fade stability of these devices was measured at 70 degree centigrade temperature and at a constant average alternating (50% duty cycle) current density of 20 mA/cm². The fade stability of these devices is also included in Table 6. The data in Table 6 shows that the device Examples 20 and 21 have the highest luminance efficiency and the highest stability. This luminance level and the stability could not be obtained if either of the dopant Alq or NPB was co-doped along with the host and blue dopant B1 such as Example 17,18, or 19. Thus, the highest performing devices were prepared with the emission layer containing both the dopants and having hole transporting properties such as NPB and the dopant with electron transporting properties such as Alq provided in the blue emission layer containing the host and the blue dopant.

Other features of the invention are included below.

The OLED device wherein the blue dopant includes distyrylamine derivatives as shown by the formula

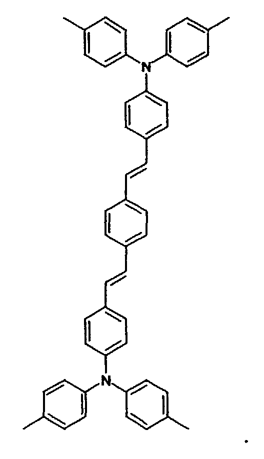

The OLED device wherein the blue emitting dopant further includes perylene and its derivatives.

The OLED device wherein the perylene derivative is 2,5,8,11-tetra-tert-butyl perylene (TBP).

The OLED device wherein the blue dopant is represented by the following formulas: 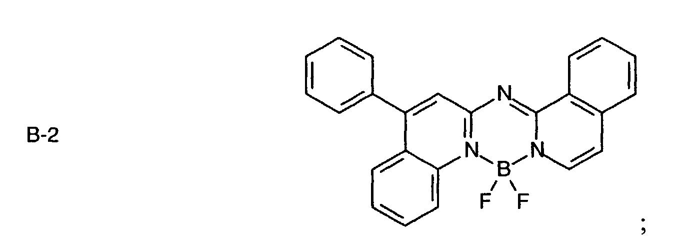 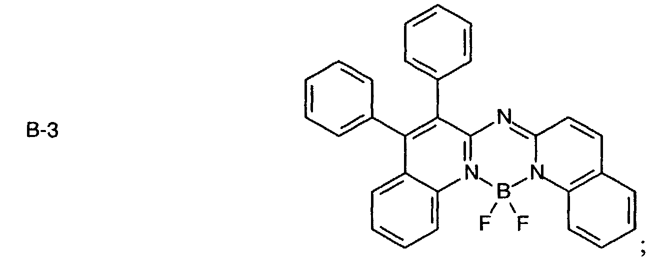 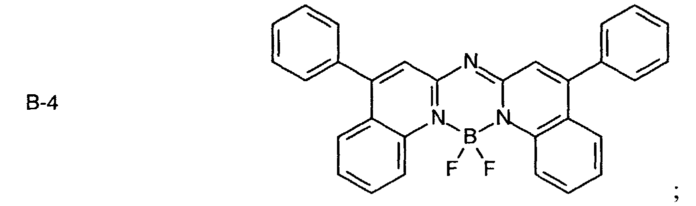 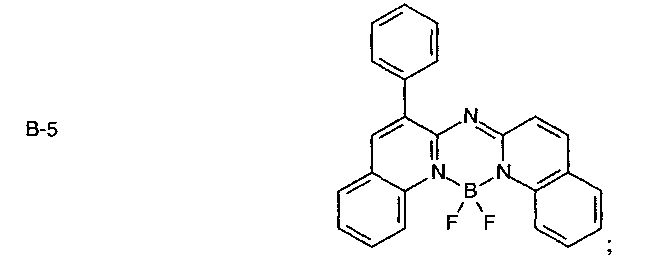 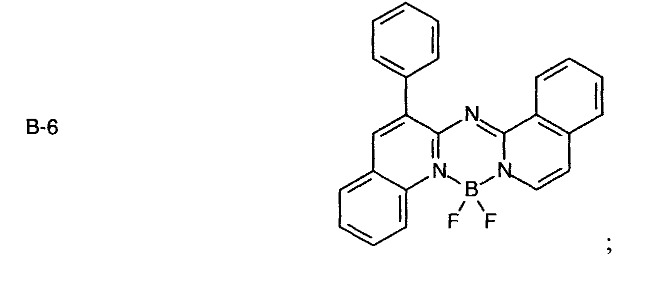 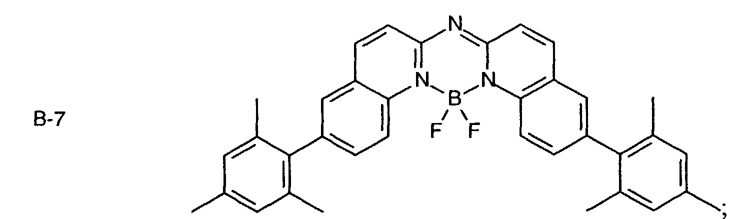 and

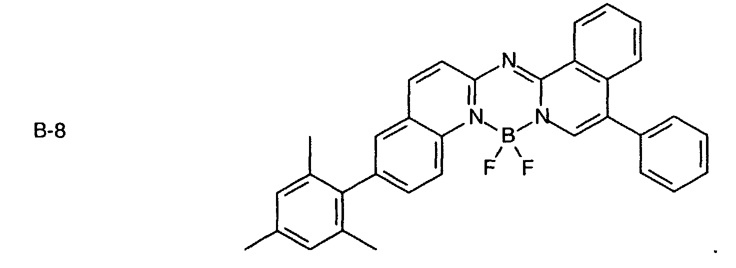

The OLED device wherein the concentration of blue emitting dopants, is in the range of greater than 0 and less than 10% percent by volume of the host material.

The OLED device wherein thickness of the hole-transporting layer is between 5 nm-300 nm.

The OLED device wherein the hole-transporting layer includes two or more sublayers, the sublayer closest to the blue light-emitting layer being doped with yellow-emitting dopants.

The OLED device wherein the dopant in the hole transport material is 5,6,11,12-tetraphenylnaphthacene (rubrene); 6,11-diphenyl-5,12-bis(4-(6-methyl-benzothiazol-2-yl)phenyl)naphthacene (DBzR); or 5,6,11,12-tetra(2-naphthyl)naphthacene (NR), and the thickness of the layer containing yellow dopant is in a range between 1 nm-300 nm.

The OLED device wherein thickness of the blue light-emitting layer is in a range between 5 nm-100 nm.

The OLED device wherein a hole-injecting layer is provided between the anode and the hole-transporting layer.

The OLED device wherein the hole-injecting layer comprises CFx, CuPC, or m-MTDATA.

The OLED device wherein the thickness of hole injecting layer is 0.1 nm-100 nm.

The OLED device wherein thickness of the electron-transporting layer is in a range between 5 nm-150 nm.

The OLED device wherein the cathode is selected from the group consisting of LiF/Al, Mg:Ag alloy, Al-Li alloy, and Mg-Al alloy.

The OLED device wherein the cathode is transparent.

The OLED device wherein the electron-transporting layer is transparent.

The organic light-emitting diode (OLED) device wherein the electron-transporting layer is doped with a green light-emitting dopant or a combination of green and yellow light-emitting dopants.

The OLED device wherein of the green dopant in the electron-transporting layer includes a coumarin compound.

The OLED device wherein the coumarin compound includes C545T or C545TB.

The OLED device wherein the green light-emitting dopant has the formula: 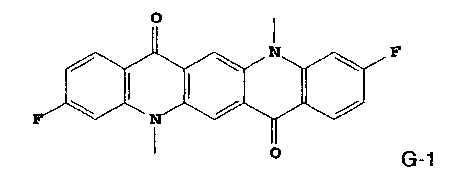 or 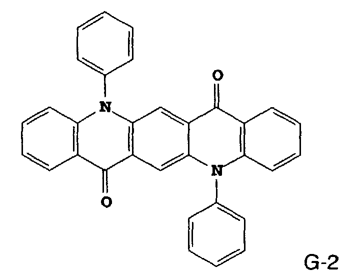 and compounds suitably represented by formulas: 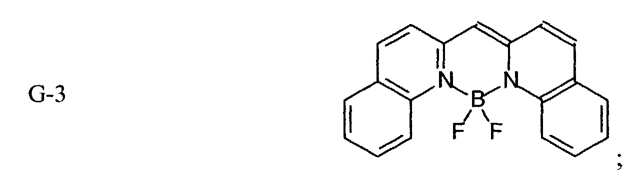 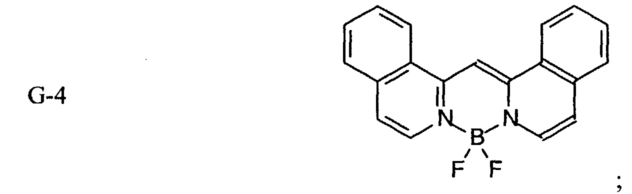 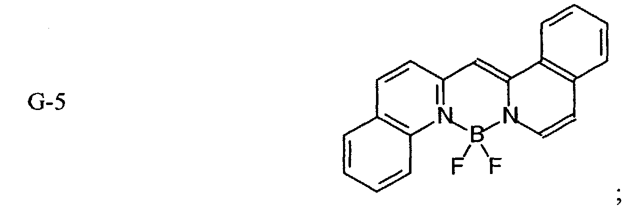 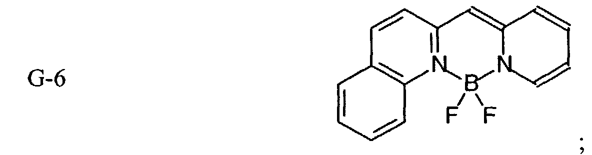 and

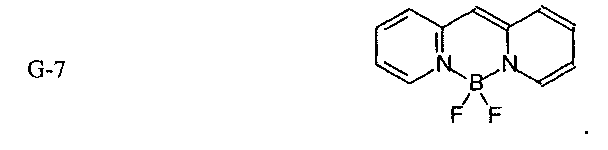

The OLED device wherein green dopant concentration is between 0.1-5% percent by volume of the host material.

The OLED device further including buffer layer disposed on the cathode layer.

The OLED device wherein thickness of the buffer layer is in a range between 1 nm-1000 nm.

The OLED device further including a color filter array disposed on the substrate or over the cathode.

The OLED device further including a color filter array disposed on the buffer layer.

The OLED device further including thin film transistors (TFTs) on the substrate to address the individual pixels.

The OLED device wherein the hole-transporting layer includes an aromatic tertiary amine.

The OLED device wherein the electron-transporting layer includes copper phthalocyanine compound.

The OLED device wherein the blue light-emitting layer includes host material selected from the group consisting of: 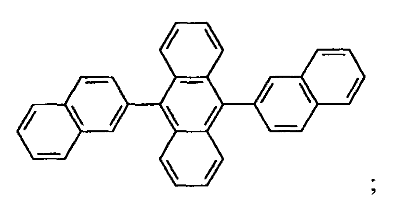 or 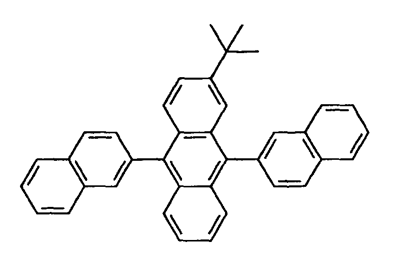 ; and a blue light-emitting dopant includes 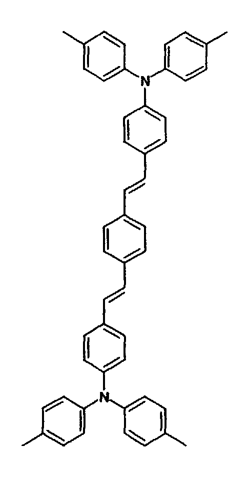 or derivatives thereof.

The OLED device wherein the blue light-emitting layer includes host material selected from the group consisting of: 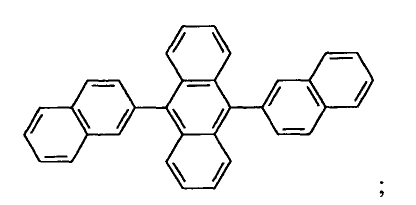 or 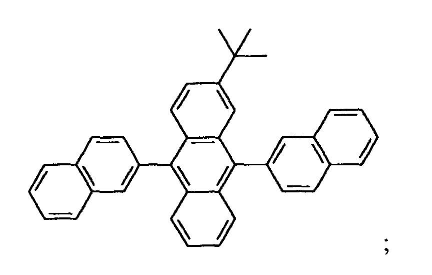 a blue light-emitting dopant includes 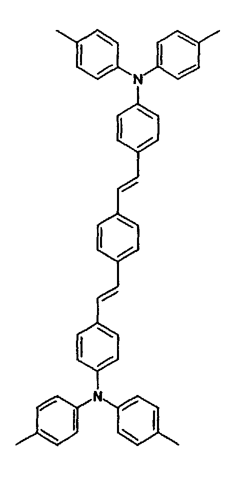 or derivatives thereof.

## Claims

1. An organic light-emitting diode (OLED) device which produces substantially white light, comprising:
a) an anode;
b) a hole-transporting layer disposed over the anode;
c) a blue light-emitting layer having a host doped with a blue light-emitting compound disposed directly on the hole-transporting layer and the blue light-emitting layer being doped with an electron-transporting or a hole-transporting material or both selected to improve efficiency and operational stability;
d) an electron-transporting layer disposed over the blue light-emitting layer;
e) a cathode disposed over the electron-transporting layer; and
f) the hole-transporting layer or electron-transporting layer, or both the hole-transporting layer and electron-transporting layer, being selectively doped with a compound which emits light in the yellow region of the spectrum which corresponds to an entire layer or a partial portion of a layer in contact with the blue light-emitting layer.

2. The OLED device of claim 1 wherein hole-transporting or the electron-transporting blue stabilizing dopant material is selected to be in a range of from .5 to 10 percent by volume of the host material and when both are used, they are selected to be in a range of from 1 to 20 percent by volume of the host material.

3. The OLED device of claim 1 wherein the hole-transporting blue stabilizing dopants in the blue light-emitting layer are:
1,1-Bis(4-di-*p*-tolylaminophenyl)cyclohexane
1,1-Bis(4-di-*p*-tolylaminophenyl)-4-phenylcyclohexane
4,4'-Bis(diphenylamino)quadriphenyl
Bis(4-dimethylamino-2-methylphenyl)-phenylmethane
N,N,N-Tri(*p*-tolyl)amine
4-(di-p-tolylamino)-4'-[4(di-p-tolylamino)-styryl]stilbene
N,N,N',N'-Tetra-*p*-tolyl-4-4'-diaminobiphenyl
N,N,N',N'-Tetraphenyl-4,4'-diaminobiphenyl
N,N,N',N'-tetra-1-naphthyl-4,4'-diaminobiphenyl
N,N,N',N'-tetra-2-naphthyl-4,4'-diaminobiphenyl
N-Phenylcarbazole
4,4'-Bis[N-(1-naphthyl)-N-phenylamino]biphenyl (NPB)
4,4'-Bis[N-(1 -naphthyl)-N-(2-naphthyl)amino]biphenyl (TNB)
4,4"-Bis[N-(1-naphthyl)-N-phenylamino]p-terphenyl
4,4'-Bis[N-(2-naphthyl)-N-phenylamino]biphenyl
4,4'-Bis[N-(3-acenaphthenyl)-N-phenylamino]biphenyl
1,5-Bis[N-(1-naphthyl)-N-phenylamino]naphthalene
4,4'-Bis[N-(9-anthryl)-N-phenylamino]biphenyl
4,4"-Bis[N-(1-anthryl)-N-phenylamino]-*p*-terphenyl
4,4'-Bis[N-(2-phenanthryl)-N-phenylamino]biphenyl
4,4'-Bis[N-(8-fluoranthenyl)-N-phenylamino]biphenyl
4,4'-Bis[N-(2-pyrenyl)-N-phenylamino]biphenyl
4,4'-Bis[N-(2-naphthacenyl)-N-phenylamino]biphenyl
4,4'-Bis[N-(2-perylenyl)-N-phenylamino]biphenyl
4,4'-Bis[N-(1-coronenyl)-N-phenylamino]biphenyl
2,6-Bis(di-*p*-tolylamino)naphthalene
2,6-Bis[di-(1-naphthyl)amino]naphthalene
2,6-Bis[N-(1-naphthyl)-N-(2-naphthyl)amino]naphthalene
N,N,N',N'-Tetra(2-naphthyl)-4,4"-diamino-*p*-terphenyl
4,4'-Bis {N-phenyl-N-[4-( 1-naphthyl)-phenyl]amino}biphenyl
4,4'-Bis[N-phenyl-N-(2-pyrenyl)amino]biphenyl
2,6-Bis[N,N-di(2-naphthyl)amine]fluorene
1,5-Bis[N-( 1-naphthyl)-N-phenylamino]naphthalene
4,4',4"-tris[(3-methylphenyl)phenylamino]triphenylamine (MTDATA)
4,4'-Bis[N-(3-methylphenyl)-N-phenylamino]biphenyl (TPD).

4. The OLED device of claim 1 wherein the electron-transporting blue stabilizing dopants in the blue light-emitting layer are:
BAlq
Aluminum trisoxine [alias, tris(8-quinolinolato)aluminum(III)]
Magnesium bisoxine [alias, bis(8-quinolinolato)magnesium(II)]
Bis[benzo{f}-8-quinolinolato]zinc (II)
Bis(2-methyl-8-quinolinolato)aluminum(III)-µ-oxo-bis(2-methyl-8-quinolinolato) aluminum(III)
Indium trisoxine [alias, tris(8-quinolinolato)indium]
Aluminum tris(5-methyloxine) [alias, tris(5-methyl-8-quinolinolato) aluminum(III)]
Lithium oxine [alias, (8-quinolinolato)lithium(I)]
Gallium oxine [alias, tris(8-quinolinolato)gallium(III)]
Zirconium oxine [alias, tetra(8-quinolinolato)zirconium(IV)].

5. The OLED device of claim 1 wherein the hole-transporting blue stabilizing dopant material is NPB and the electron-transporting blue stabilizing material is Alq.

6. The OLED device of claim 1 wherein the hole-transporting blue stabilizing dopant material is NPB and the electron-transporting blue stabilizing dopant material is BAlq.

7. The OLED device of claim 1 wherein the yellow light-emitting compound is: 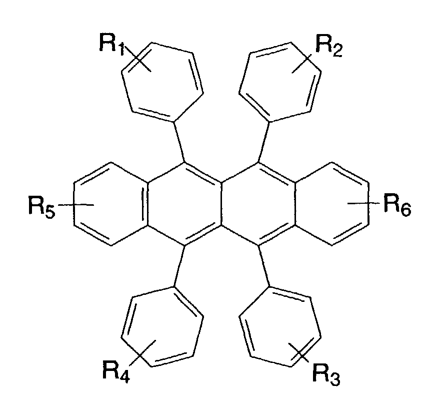 wherein R₁, R₂, R₃, R₄, R₅, R₆ represent one or more substituents on each ring where each substituent is individually selected from the following groups:
Group 1: hydrogen, or alkyl of from 1 to 24 carbon atoms;
Group 2: aryl or substituted aryl of from 5 to 20 carbon atoms;
Group 3: carbon atoms from 4 to 24 necessary to complete a fused aromatic ring of phenyl, naphthyl, anthracenyl, phenanthryl, pyrenyl, or perylenyl;
Group 4: heteroaryl or substituted heteroaryl of from 5 to 24 carbon atoms such as thiazolyl, furyl, thienyl, pyridyl, quinolinyl or other heterocyclic systems, which may be bonded via a single bond, or may complete a fused heteroaromatic ring system;
Group 5: alkoxylamino, alkylamino, or arylamino of from 1 to 24 carbon atoms; or
Group 6: fluorine, chlorine, bromine or cyano.

8. The OLED device of claim 6 wherein the yellow-emitting dopants includes 5,6,11,12-tetraphenylnaphthacene (rubrene); 6,11-diphenyl-5,12-bis(4-(6-methyl-benzothiazol-2-yl)phenyl)naphthacene (DBzR) or 5,6,11,12-tetra(2-naphthyl)naphthacene (NR), the formulas of which are shown below: 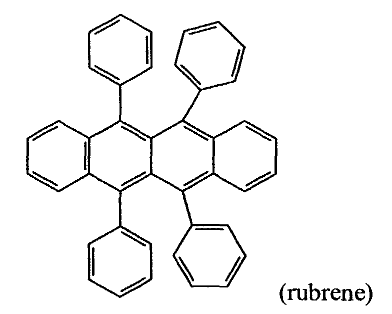 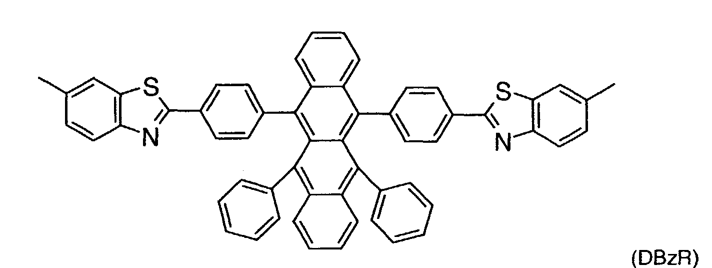 or

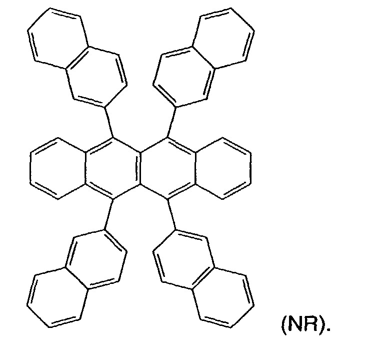

9. The OLED device of claim 7 wherein the concentration of yellow-emitting dopants 5,6,11,12-tetraphenylnaphthacene (rubrene); 6,11-diphenyl-5,12-bis(4-(6-methyl-benzothiazol-2-yl)phenyl)naphthacene (DBzR) or 5,6,11,12-tetra(2-naphthyl)naphthacene (NR) is in a range of greater than 0 and less than 30% percent by volume of the host material.

10. The OLED device of claim 7 wherein the concentration of yellow-emitting dopants 5,6,11,12-tetraphenylnaphthacene (rubrene); 6,11-diphenyl-5,12-bis(4-(6-methyl-benzothiazol-2-yl)phenyl)naphthacene (DBzR) or 5,6,11,12-tetra(2-naphthyl)naphthacene (NR) is preferably in a range of greater than 0 and less than 15 % percent by volume of the host material.
